(19) Europäisches Patentamt
European Patent Office
Office européen des brevets

(11) Veröffentlichungsnummer: **0 025 167**
**B1**

(12) **EUROPÄISCHE PATENTSCHRIFT**

(45) Veröffentlichungstag der Patentschrift: **03.12.86**

(51) Int. Cl.⁴: **G 11 C 19/28, G 11 C 27/02**

(21) Anmeldenummer: **80105056.8**

(22) Anmeldetag: **26.08.80**

(54) Eingangsstufe für eine monolithisch integrierte Ladungsverschiebeanordnung.

(30) Priorität: **11.09.79 DE 2936682**

(43) Veröffentlichungstag der Anmeldung:
**18.03.81 Patentblatt 81/11**

(45) Bekanntmachung des Hinweises auf die
Patenterteilung:
**03.12.86 Patentblatt 86/49**

(84) Benannte Vertragsstaaten:
**FR GB**

(56) Entgegenhaltungen:
**DE-A-2 419 064
DE-A-2 429 633
DE-A-2 844 248**

**IEEE JOURNAL OF SOLID-STATE CIRCUITS,
Band SC-12, Nr. 6, Dezember 1977, Seiten
633-637, D.A. SEALER et al.: "A dual-differential
analog shift register with a charge-splitting
input and on-chip peripheral circuits"**

(73) Patentinhaber: **Siemens Aktiengesellschaft
Berlin und München
Wittelsbacherplatz 2
D-8000 München 2 (DE)**

(72) Erfinder: **Knauer, Karl, Dipl.-Ing.
Am Dachsberg 13
D-8011 Kirchseeon (DE)**

(56) References cited:
**IEEE TRANSACTIONS ON ELECTRON
DEVICES, Band ED-24, Nr. 6, Juni 1977, Seiten
746-750, C.H. SEQUIN et al.: "A symmetrically
balanced linear differential charge-splitting
input for charge-coupled devices"**

**Beschreibung**

Die Erfindung bezieht sich auf eine Eingangsstufe eine monolithisch integrierten Ladungsverschiebeanordnung nach den gleichlautenden Oberbegriffen der Patentansprüche 1 und 2.

Eine Eingangstufe dieser Art wird beispielsweise in dem Aufsatz "A Symmetrical Balanced Linear Differential Charge-Splitting Input for Charge-Coupled Devices" in den IEEE Transactions on Electron Devices, Vol. ED-24, No. 6, Juni 1977, Seiten 746—750, beschrieben. Hierbei sind zwei nebeneinander liegende Eingangsgateelektroden vorgesehen, die mit Spannungen unterschiedliche Größe beschaltet sind, wobei sich diese Spannungen jeweils um den Betrag eines Eingangssignals voneinander unterscheiden Zwischen den Eingangsgateelektroden ist ein streifenförmiges Trennungsgate angeordnet. Aus einem Source-Gebiet stammende Ladungspakete konstanter Größe werden mittels der Transfergateelektroden in den Halbleiterbereich unterhalb der beiden Eingangsgateelektroden verschoben, wo sie sich entsprechend den an diesen liegenden unterschiedlichen Spannungen auf die unter ihnen gebildeten Potentialsenken aufteilen. Nach dieser Aufteilung in zwei komplementäre Ladungspakete wird dem Trennungsgate eine solche Spannungs zugeführt, daß zwischen denselben eine Potentialbarriere entsteht. Die komplementären Ladungspakete werden in zwei getrennten Übertragungskanälen der Ladungsverschiebeanordnung schrittweise in Richtung auf deren Ausgänge verschoben. Nachteilig ist hierbei der durch die beiden Eingangsgateelektroden und die beiden Übertragungskanäle bedingte große Bedarf an Halbleiterfläche. Außerdem können im Bereich der beiden Übertragungskanäle unterschiedliche Haftstellenkonzentrationen an der Halbleitergrenzfläche vorliegen, so daß die beiden komplementären Ladungspakete unterschiedlichen Beeinflussungen durch thermische Grundladungen ausgesetzt sind.

Der Erfindung liegt die Aufgabe zugrunde, eine Eingangsstufe der eingangs genannten Art enzugeben, bei der die vorstehenden Nachteile vermieden sind. Das wird erfindungsgemäß durch eine Ausbildung der Eingangsstufe gemäß den kennzeichnenden Merkmalen der Patentansprüche 1 oder 2 erreicht.

Der mit der Erfindung erzielbare Vorteil besteht insbesondere darin, daß die Eingangsstufe und der sich anschließende Übertragungskanal der Ladungsverschiebeanordnung auf einer wesentlich kleineren Halbleiterfläche aufgebaut werden können als die entsprechenden Teile der bekannten Ladungsverschiebeanordnungen. Weiterhin ergeben sich für die in ein und demselben Übertragungskanal verschobenen komplementären signalabhängigen Ladungspakete jeweils gleiche Beeinflussungen durch thermische Grundladungen.

Der Anspruch 3 betrifft eine vorteilhafte Anwendung der Eingangsstufe nach der Erfindung.

Die Erfindung wird nachfolgend anhand der in der Zeichnung dargestellten Ausführungsbeispiele näher erläutert. Dabei zeigt:

Fig. 1 ein erstes Ausführungsbeispiel,

Fig. 2 Spannungs-Zeit-Diagramme zur Erläuterung von Fig. 1,

Fig. 3 ein zweites Ausführungsbeispiel und

Fig. 4 eine CTD-Anordnung, die mit einer nach den Figuren 1 oder 3 ausgebildeten Eingangsstufe versehen ist.

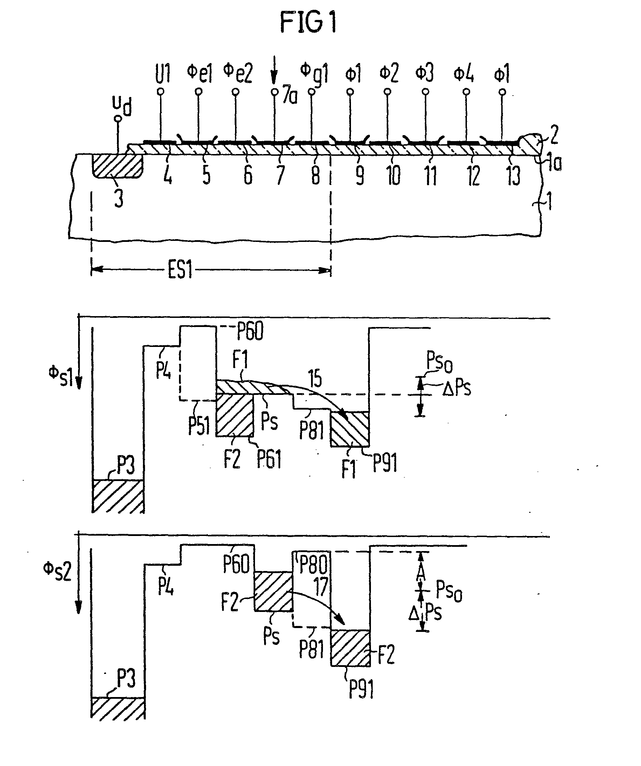

In Fig. 1 ist ein dotierter Halbleiterkörper eines vorgegebenen Leitfähigkeitstyps mit 1 bezeichnet. Er besteht beispielsweise aus p-dotiertem Silizium. Seine Grenzfläche 1a ist mit einer dünnen elektrisch isolierenden Schicht 2 bedeckt, die insbesondere aus $SiO_2$ bestehen kann und in diesem Fall als Gateoxidschicht bezeichnet wird. An der Grenzfläche 1a befindet sich ein n-leitendes Gebiet 3, das durch einen Diffusions- oder Implantationsvorgang erzeugt wird. Der neben diesem Gebiet liegende Bereich des Halbleiterkörpers 1 wird von einem ersten Gate 4, zwei Transfergateelektroden 5 und 6, einem Eingangsgate 7 und einem zweiten Gate 8 überdeckt, die auf der isolierenden Schicht 2 angeordnet sind. Die Schaltungsteile 3 bis 8 bestimmen der Halbleiterbereich einer CTD-Eingangsstufe ES1, wobei "CTD" eine monolithisch integrierte Ladungsverschiebeanordnung bezeichnet.

An das Gate 8 schließen sich eine Reihe von Transfer-elektroden 9 bis 13 an, die ebenfalls auf der Isolierschicht 2 angeordnet ist. Jeweils view aufeinanderfolgende Transferelektroden, z. B. 9 bis 12, sind über ihre Anschlüsse mit jeweils einer von vier gegeneinander phasenverschobenen Taktspannungen Ø1 bis Ø4 beschaltet. Die Elektroden 9 bis 12 kennzeichnen dabei die erste Der Eingangsstufe ES nachgeordnete Stufe einer CTD-Anordnung. Es schließen sich weitere CTD-Stufen an, von denen in Fig. 1 nur die erste Transferelektrode 13 der zweiten Stufe dargestellt ist, die mit der Taktspannung Ø1 beschaltet ist. Der Bereich an der Oberfläche des Halbleiterkörpers 1 unterhalb der Elektroden 9 bis 13 usw. stellt dabei den CTD-Übertragungskanal dar.

Dem Gebiet 3 wird über seinen dargestellten Anschluß eine Taktimpulsspannung $u_d$ zugeführt, während das erste Gate 4 über seinen Anschluß mit einer konstanten Spannung U1 beschaltet ist. Die Transfergateelektroden 5 und 6 sind mit Taktimpulsspannungen $Ø_{e1}$ und $Ø_{e2}$ beschaltet, die gegeneinander phasenverschoben sind. Dem Eingangsgate 7 wird über seinen Anschluß 7a ein Eingangssignal $u_e$ zugeführt, während das zweite Gate 8 mit einer Taktimpulsspannung $Ø_{g1}$ beschaltet ist.

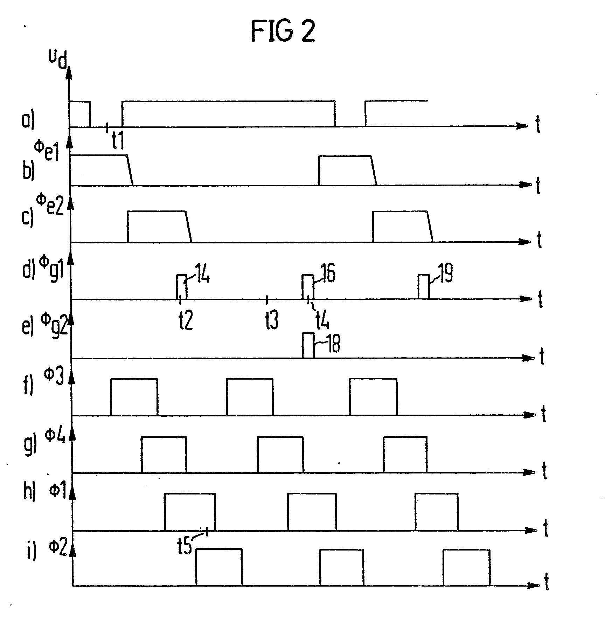

Die Wirksungsweise der Eingangsstufe ES1 wird nachfolgend anhand der in Fig. 1 eingezeichneten Verläufe $Ø_{s1}$ und $Ø_{s2}$ des an der Grenzfläche 1a bestehenden Oberflächenpotentials und der Spannungs-Zeit-Diagramme der Fig. 2 näher beschrieben. Fig. 2a zeigt dabei den zeitlichen Verlauf der Taktimpulsspannung $u_d$, die Figuren 2b und 2c die Zeitabhängigkeiten der Taktimpulsspannungen $\emptyset_{e1}$ und $\emptyset_{e2}$. In Fig. 2d ist ser zeitliche Verlauf der dem zweiten Gate zugeführten Taktimpulsspannung $\emptyset_{g1}$ angegeben. Zum Zeitpunkt t1 ist die Spannung $u_d$ auf einen sehr kleinen Wert reduziert, was zu einer Überschwemmung des Halbleitergebietes unterhalb des Gate 4 und des Transfergate 5 mit Ladungsträgern führt, die aus dem Gebiet 3 injiziert werden. Nach dem Wiederanstieg von $u_d$ auf den Wert $u_{do}$, der dem Oberflächenpotential P3 entspricht, fließt der überwiegende Teil der Ladungsträger wieder in das Gebiet 3 zurück, wobei lediglich diejenigen Ladungsträger, die sich in der während des Auftretens eines Taktimpulses $\emptyset_{e1}$ unterhalb von 5 ausgebildeten Potentialsenke P51 befinden und dieses bis zu der durch das Potential P4 gegebenen randseitigen Potentialschwelle auffüllen, in der Senke P51 zurückbleiben.

Vor dem Auftreten des nächstfolgenden Taktimpulses $\emptyset_{e2}$ ist die Senke P51 nach rechts durch das Potential P60 unterhalb von 6 begrenzt. Zum Zietpunkt t2 liegt dann ein Taktimpuls $\emptyset_{e2}$ an dem Transfergate 6, so daß sich unter diesem eine Potentialsenke P61 bildet, an die das in P51 befindliche Ladungspaket nach Beendigung des Taktimpulses $\emptyset_{e1}$ weitergegeben wird.

In Fig. 1 ist der zum Zeitpunkt t2 auftretende Verlauf des Oberflächenpotentials durch eine ausgezogene Linie dargestellt und mit $\emptyset_{s1}$ bezeichnet. Das an die Senke P61 weitergegebene Ladungspaket wird von dieser nur zum Teil aufgenommen, da die rechtseitige Begrenzung der Senke P61 durch das Potential $P_s$ gebildet wird, das sich unterhalb des Eingangsgate 7 in Abhängigkeit von dem jeweils anliegenden Eingangssignal $u_e$ ausbildet. Durch eine dem Anschluß 7a zusätzlich zugefuhrte Vorspannung wird der Gleichspannungsanteil von $u_e$ so eingestellt, daß sich für den an 7a auftretenden Spannungshub ein Potentialhub $\Delta P_s$ ergibt. Für den minimalen Signalspannungswert, der ein Oberflächenpotential $P_{so}$ erzeugt, soll das gesamte, durch die Flächen F1 und F2 dargestellte Ladungspaket von der Senke P61 gerade aufgenommen werden. Bei dem betrachteten mittleren Eingangssignalwert, der das Potential $P_s$ ergibt, wird jedoch der durch F1 gegebene Teil des Ladungspaketes beim Auftreten des Taktimpulses 14 wegen des Potentials P81 unterhalb des zweiten Gate 8 in die wegen des Taktimpulses $\emptyset1$ unterhalb von 9 gebildete Senke P91 transportierte, was durch den Pfeil 15 angedeutet ist. Der durch F1 gekennzeichnete Teil des Ladungspaketes stellt also ein erstes Teilladungspaket dar, das mit größer werdendem Eingangssignal $u_e$ anwächst. Daher wird das Eingangssignal durch das erste Teilladungspaket (F1) positiv bewertet.

Zum Zeitpunkt t3 besteht unterhalb des zweiten Gate 8 eine Potentialschwelle P80, die den rechten Rand einer Potentialsenke $P_s$ darstellt, deren linker Rand durch das nach Beendigung des Taktimpulses $\emptyset_{e2}$ unterhalb des Transfergate 6 bestehenden Potentials P60 gebildet wird. In Fig. 1 ist der Verlauf des gesamten Oberflächenpotentials der Eingangsstufe ES1 zum Zeitpunkt t3 mit $\emptyset_{s2}$ bezeichnet und durch eine ausgezogene Linie dargestellt. Wie hieraus hervorgeht, befindet sich das mit F2 bezeichnete, zweite Teilladungspaket zu diesem Zeitpunkt in der Senke $P_s$. Dabei ist vorausgesetzt, daß der Potentialwert P80 um einen vorgegebenen Betrag A unterhalb von $P_{so}$ liegt. Zum Zeitpunkt t4 ist dann die Potentialschwelle P80 beim Auftreten des Taktimpulses 16 wieder durch den Potentialwert P81 ersetzt, wobei das zweite Teilladungspaket in die durch den gleichzeitig auftretenden Taktimpuls $\emptyset1$ gebildete Senke P91 transportiert wird (Pfeil 17).

Das erste Teilladungspaket F1 und das zweite Teilladungspaket F2 sind, da sie sich zu einer konstanten Ladungsmenge ergänzen, zueinander komplementär. Dabei ist das erste Teilladungspaket F1 um so größer und das zweite Teilladungspaket F2 um so kleiner, je größer der zu Beginn des Taktimpulses 14 auftretende Wert des Eingangssignals $u_e$ ist. Das erste Teilladungspaket F1 bewertet also das Eingangssignal $u_e$ positiv, während das zweite Teilladungspaket F2 das Signal $u_e$ negativ bewertet. Unter dem Einfluß der in Fig. 2f bis Fig. 2i dargestellten Taktimpulsspannungen $\emptyset1$ bis $\emptyset4$ ist das erste Teilladungspaket F1 bereits unter der Transferelektrode 13 angelangt, wenn das zweite Teilladungspaket F2 unter die Transferelektrode 9 verschoben wird. Damit werden durch die Eingangsstufe $u_e$ zwei Teilladungspakete F1 und F2 abgeleitet, deren Ladungsdifferenz ein Maß für den Abtastwert von $u_e$ darstellt. Dabei weisen die Taktimpulsspannungen $u_d$, $\emptyset_{e1}$ und $\emptyset_{e2}$ Taktfrequenzen auf, die der halben Taktfrequenz der Impulsspannungen $\emptyset_{g1}$ und $\emptyset1$ bis $\emptyset4$ entsprechen.

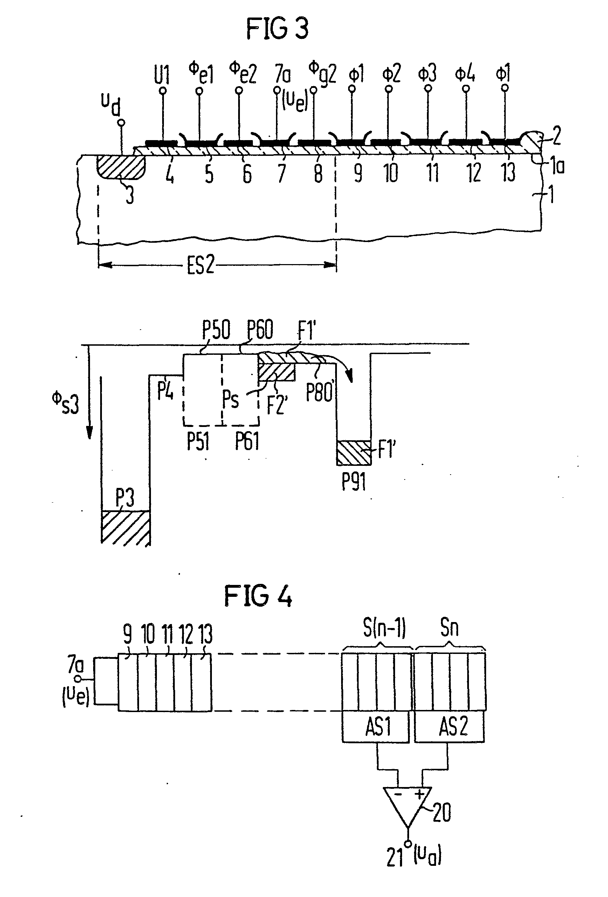

Fig. 3 zeigt ein zweites Ausführungsbeispiel der Eingangsstufe nach der Erfindung, das mit dem in Fig. 1 dargestellten strukturell übereinstimmt. Die bereits anhand der Fig. 1 beschriebenen Schaltungsteile und Potentialwerte sind daher in Fig. 3 mit denselben Bezugszeichen versehen. Die mit ES2 bezeichnete Eingangsstufe der Fig. 3 ist zum Unterschied von der Eingangsstufe ES1 bezüglich des zweiten Gate 8 mit einer Taktimpulsspannung $\emptyset_{g2}$ beschaltet, die in Fig. 2e in ihrem zeitlichen Verlauf dargestellt ist. Dabei ist die Taktfrequenz von $\emptyset_{g2}$ halb so groß wie die von $\emptyset_{g1}$ und entspricht damit der Taktfrequenz der Spannungen $u_d$, $\emptyset_{e1}$ und $\emptyset_{e2}$. Fig. 2e zeigt daher nur einen Taktimpuls 18 von $\emptyset_{g2}$, der zeitlich mit dem Taktimpuls 16 von $\emptyset_{g1}$ zusammenfällt, während keine den Taktimpulsen 14 und 19 entsprechenden Taktimpulse vorhanden sind.

Der untere Spannungswert von $\emptyset_{g2}$ entspricht dem minimalen Wert des Eingangssignal $u_e$, während der obere Spannungswert von $\emptyset_{g2}$ den Maximalwert des Eingangssignals $u_e$ nicht unterschreiten darf. Die übrigen in den Figuren 2a bis 2c und 2f bis 2g dargestellten Taktimpulsspannungen werden auch der Eingangsstufe ES2 zugeführt.

Bei der Betrachtung der Wirkungsweise der Eingangsstufe ES2 sei davon ausgegangen, daß zum Zeitpunkt t5 der in Fig. 3 mit kontinuierlichen Linien eingezeichnete und mit $\emptyset_{s3}$ bezeichnete Verlauf des Oberflächenpotentials gilt. Dabei entspricht das Oberflächenpotential unterhalb des Transfergate 6 dem Wert P60, während der untere Spannungswert von $\emptyset_{g2}$ unter dem zweiten Gate 8 ein Potential P80' erzeugt, das dem Potential $P_{s0}$ gleichkommt. Das während des Auftretens eines Taktimpulses $\emptyset_{e2}$ in der Senke P61 befindliche Ladungspaket wird dann nach der Beendigung dieses Impulses in den Halbleiterbereich unterhalb der Elektroden 7 bis 9 transportiert. Dabei wird das gesamte Ladungspaket für den Fall, daß gerade der maximale Wert des Eingangssignals $u_e$ anliegt, von der Potentialsenke $P_s$ aufgenommen. Für den dargestellten Fall eines mitteleren Eingangssignalwertes, der das Potential $P_s$ entstehen läßt, gelangt ein erstes Ladungspaket, das in Fig. 3 mit F1' bezeichnet ist, über die Schwelle P80' in die Potentialsenke P91, die wegen des gleichzeitigen Auftretens eines Taktimpulses $\emptyset1$ unterhalb der Elektrode 9 gebildet wird. Ein zweites Ladungspaket, das durch F2' angedeutet ist, verbleibt zunächst in der Potentialsenke $P_s$. Erst beim Auftreten des Taktimpulses 18 zum Zeitpunkt t4 (Fig. 2e) gelangt dann auch das zweite Teilladungspaket F2' in die neuerlich entstandene Potentialsenke P91. Das erste Teilladungspaket F1' bewertet hierbei den zum Zeitpunkt der Beeindigung des Taktimpulses $\emptyset_{e2}$ abgetasteten Wert des Eingangssignals $u_e$ negativ während das zweite Teilladungspaket F2' diesen Signalwert positiv bewertet. Wenn F2' in die Senke P91 gelangt, ist das erste Teilladungspaket F1' unter dem Einfluß der Taktimpulsspannungen $\emptyset1$ bis $\emptyset4$ bereits unter die Elektrode 13 verschoben worden. Die Differenzladung zwischen den Teilladungspaketen F1' und F2' stellt ein Maß für den abgetasteten Wert des Eingangssignals $u_e$ dar.

In Fig. 4 ist eine mit einer Eingangsstufe ES1 ausgestattete CTD-Anordnung dargestellt. Die ersten Transferelektroden des Übertragungskanals sind dabei entsprechend den Figuren 1 und 3 mit 11 bis 13 bezeichnet. Die letzten beiden CTD-Stufen sind mit S(n−1) und Sn bezeichnet. Diese Stufen sind jeweils mit einer Ausgangsstufe AS1 bzw. AS2 gekoppelt, die ihrerseits mit dem negativen und positiven Eingang eines Differenzverstärkers 20 verbunden sind. Am Ausgang 21 desselben ist ein Ausgangssignal $u_a$ abgreifbar. Die Stufen S(n−1) und Sn weisen jeweils vier im einzelnen nicht dargestellte Transferelektroden auf. Die Ausgangsstufen AS1 und AS2 sind z.B. mit intermittierend von äußeren Potentialen freigeschalteten Diffusionsgebieten oder Gateelektroden ausgebildet, die mit einer Transistorstufe verbunden sind, wie dies beispielweise in dem Buch von Sequin und Tompsett "Charge Transfer Devices", Academic Press, New York 1975, auf den Seiten 52 bis 56 beschrieben ist. Auch in den 1974 WESCON Technical Papers, Vol. 18, sind solche als "floating diffusion outputs" und "floating gate outputs" bezeichneten Ausgangsstufen in dem Aufsatz "Charge-Coupled Devices—an Overview" von W. F. Kosonocki auf Seite 7 der Sektion 2/1 näher beschrieben. Die Stufen AS1 und AS2 werden mit einer Taktfrequenz betrieben, die der der Taktimpulsspannungen $u_d$, $\emptyset_{e1}$ und $\emptyset_{e2}$ entspricht, so daß jeweils ein von ES1 geliefertes, erstes Teilladungspaket F1 von AS2 und gleichzeitig das zu demselben Abtastwert von $u_e$ gehörende zweite Teilladungspaket F2 von AS1 ausgewertet werden. Aus den von AS1 und AS2 gebildeten Auswertesignalen wird dann im Verstärker 20 das Differenzsignal $u_a$ gebildet, das dem abgetasteten Signalwert $u_a$ entspricht. Verwendet man in Fig. 4 anstelle der Stufe ES1 die Eingangsstufe ES2, so müssen die Eingänge des Differenzverstärkers 20 miteinander vertauscht werden. Der Vorteil einer solchen CTD-Anordnung besteht auch darin, daß Beeinflussungen der Ladungspakete durch an der Grenzfläche 1a befindliche Haftstellen (traps), die sich auf das erste und zweite Teilladungspakete jeweils in gleicher Weise auswirken, durch die im Verstärker 20 vorgenommene Differenzbildung außer Betracht bleiben können.

Bisher wurde von einer CTD-Anordnung ausgegangen, die als eine SCCD-Anordnung ausgebildet ist. Hierunter versteht man eine ladungsgekoppelte Anordnung, bei der die Ladungen an der Oberfläche des Halbleiterkörpers 1 verschoben werden. Darüber hinaus kann die Erfindung auch mit CTD-Anordnungen realisiert werden, bei denen ein Ladungstransport im Inneren des Halbleiterkörpers 1 erfolgt und die unter der Bezeichnung "BCCD" zusammengefaßt werden. Allgemein ist bei der Erfindung jede Anordnung einsetzbar, die unter den Begriff Ladungsverschiebeanordnung (CTD) fällt, wie er beispielsweise in dem genannten Buch von Sequin und Tompsett "Charge Transfer Devices" auf den Seiten 1 bis 18 erläutert ist. Diese Ladungsverschiebeanordnungen können dabei entsprechend ihrem Aufbau im Zwei-, Drei-, Vier- und Mehrphasenbetrieb arbeiten.

Wir die Eingangsstufe nach der Erfindung in bzw. auf einem n-leitenden Siliziumkörper 1 vorgesehen, so ist das Gebiet 3 p-leitend auszubilden, wobei die in Fig. 2 dargestellten, positiven Taktimpulsspannungen durch entsprechende negative Spannungen zu ersetzen sind.

**Patentansprüche**

1. Eingangsstufe zur Eingabe von zwei komplementären, in Abhängigkeit von einem Eingangssignal gebildeten Ladungspaketen in eine monolithisch integrierte Ladungsverschiebeanordnung, bei der ein dotierter Halbleiterkörper mit einem entgegengesetzt dotierten Gebiet versehen und an einer Grenzfläche mit einer elektrisch isolierenden Schicht bedeckt ist und bei der auf der Isolierschicht ein mit einer festen Vorspannung beschaltetes, erstes Gate und ein mit einem Eingangssignal beschaltetes Eingangsgate angeordnet ist, zwischen denen wenigstens zwei Transfergateelektroden vorgesehen sind, dadurch gekennzeichnet, daß zwischen dem Eingangsgate (7) und einer Reihe von Transferelektroden (9 . . . 13), die den Übertragungskanal der Ladungsverschiebeanordnung überdecken, ein zweites Gate (8) vorgesehen ist, daß das Gebiet (3) und die Transfergateelektroden (5, 6) mit ersten Taktimpulsspannungen ($u_d$, $\varnothing_{e1}$, $\varnothing_{e2}$) beschaltet sind, daß die Transferelektroden (9 . . . 13) mit zweiten Taktimpulsspannungen ($\varnothing 1$ bis $\varnothing 4$) beschaltet sind, die eine doppelt so hohe Taktfrequenz aufweisen wie die ersten Taktimpulsspannungen ($u_d$, $\varnothing_{e1}$, $\varnothing_{e2}$), daß das zweite Gate (8) mit einer dritten Taktimpulsspannung ($\varnothing_{g1}$) beschaltet ist deren Taktfrequenz der der zweiten Taktimpulsspannungen ($\varnothing 1$ bis $\varnothing 4$) entspricht und daß die dritte Taktimpulsspannung ($\varnothing_{g1}$) zwischen zwei Spannungswerten alterniert, von denen der obere den maximalen Signalspannungswert nicht unterschreitet, während der untere um einen vorgegebenen Betrag (a) kleiner ist als der minimale Signalspannungswert.

2. Eingangsstufe zur Eingabe von zwei komplementären, in Abhängigkeit von einem Eingangssignal gebildeten Ladungspaketen in eine monolithisch integrierte Ladungsverschiebeanordnung, bei der ein dotierter Halbleiterkörper mit einem entgegengesetzt dotierten Gebiet versehen und an einer Grenzfläche mit einer elektrisch isolierenden Schicht bedeckt ist und bei der auf der Isolierschicht ein mit einer festen Vorspannung beschaltetes, erstes Gate und ein mit einem Eingangssignal beschaltetes Eingangsgate angeordnet ist, zwischen denen wenigstens zwei Transfergateelektroden vorgesehen sind, dadurch gekennzeichnet, daß zwischen dem Eingangsgate (7) und einer Reihe von Transferelektroden (9 . . . 13), die den Übertragungskanal der Ladungsverschiebeanordnung überdecken, ein zweites Gate (8) vorgesehen ist, daß das Gebiet (3) und die Transfergateelektroden (5, 6) mit ersten Taktimpulsspannungen ($u_d$, $\varnothing_{e1}$, $\varnothing_{e2}$) beschaltet sind, daß die Transferelektroden (9 . . . 13) mit zweiten Taktimpulsspannungen ($\varnothing 1$ bis $\varnothing 4$) beschaltet sind, die eine doppelt so hohe Taktfrequenz aufweisen wie die ersten Taktimpulsspannungen ($u_d$, $\varnothing_{e1}$, $\varnothing_{e2}$), daß das zweite Gate (8) mit einer dritten Taktimpulsspannung ($\varnothing_{g2}$) beschaltet ist, deren Taktfreuqnez der der ersten Taktimpulsspannungen ($u_d$, $\varnothing_{e1}$, $\varnothing_{e2}$) entspricht und daß die dritte Taktimpulsspannung ($\varnothing_{g2}$) zwischen zwei Spannungswerten alterniert, von denen der obere den maximalen Signalspannungswert nicht unterschreitet, während der untere dem minimalen Signalspannungswert entspricht.

3. Eingangsstufe nach einem der Ansprüche 1 oder 2, gekennzeichnet durch die Anwendung bei einer Ladungsverschiebeanordnung, bei der zwei benachbarte Stufe (S(n−1), Sn) mit jeweils einer Ausgangsstufe (AS1, AS2) gekoppelt sind und die letzteren mit den Eingängen eines Differenzverstärkers (20) verbunden sind.

**Revendications**

1. Etage d'entrée pour introduire deux paquets de charges complémentaires, formés en fonction d'un signal d'entrée, dans un dispositif monolithique intégré de déplacement de charges, dans lequel un corps semi-conducteur dopé est pourvu d'une région à dopage inverse et est recouvert d'une couche électriquement isolante au droit d'une surface limitée, et dans lequel une première électrode de commande soumise à une tension de polarisation fixe et une porte d'entrée soumise à un signal d'entrée sont disposées sur la couche isolante, avec interposition d'au moins deux électrodes de portes de transfert entre elles, caractérisé en ce qu'une seconde électrode de commande (8) est prévue entre la porte d'entrée (7) et une série d'électrodes de transfert (9 . . . 13) qui recouvrent le canal de transport du dispositif de déplacement de charges, que la région (3) et les électrodes de portes de transfert (5, 6) sont soumises à de premières tensions impulsionnelles d'horloge ($u_d$, $\varnothing_{e1}$, $\varnothing_{e2}$), que les électrodes de transfert (9 . . . 13) sont soumises à de secondes tensions impulsionnelles d'horloge ($\varnothing 1$ à $\varnothing 4$) qui présentent une fréquence d'horloge double de celle des premières tensions d'horloge ($u_d$, $\varnothing_{e1}$, $\varnothing_{e2}$), que la seconde électrode de commande (8) est soumise à une troisième tension impulsionnelle d'horloge ($\varnothing_{g1}$) dont la fréquence d'horloge correspond à celle des secondes tensions d'horloge ($\varnothing 0$ à $\varnothing 4$) et que la troisième tension d'horloge ($\varnothing_{g1}$) passe alternativement de l'une à l'autre de deux valeurs de tension dont la plus élevée ne descend pas en-dessous de la valeur maximale de la tension du signal d'entrée, tandis que la plus basse est inférieure d'une quantité préfixée (a) à la valeur minimale de la tension du signal d'entrée.

2. Etage d'entrée pour introduire deux paquets de charges complémentaires, formés en fonction d'un signal d'entrée, dans un dispositif monolithique intégré de déplacement de charges, dans lequel un corps semiconducteur dopé est pourvu d'une région de dopage inverse et est recouvert d'une couche électriquement isolante au droit d'une surface limite, et dans lequel une première électrode de commande soumise à une tension de polarisation fixe et une porte d'entrée soumise à un signal d'entrée sont disposées sur la couche isolante, avec interposition d'au moins deux électrodes de portes de transfert entre elles, caractérisé en ce qu'une seconde électrode de commande (8) est prévue entre la porte d'entrée (7) et une série d'électrodes de transfert (9 . . . 13) qui recouvrent le canal de transport du dispositif de déplacement de charges, que la région (3) et les électrodes de portes de transfert (5, 6) sont soumises à de premières tensions impulsionnelles d'horloge ($u_d$, $\varnothing_{e1}$, $\varnothing_{e2}$), que les électrodes de transfert (9 . . . 13) sont soumises à de secondes tensions impulsionnelles d'horloge ($\varnothing 1$ à $\varnothing 4$) qui présentent une fréquence d'horloge double de celle des premières tensions d'horloge ($u_d$, $\varnothing_{e1}$, $\varnothing_{e2}$), que la seconde électrode de commande (8) est soumise à une troisième tension impulsionnelle d'horloge ($\varnothing_{g2}$) dont la fréquence d'horloge correspond à celle des premières tensions d'horloge ($u_d$, $\emptyset_{e1}$, $\emptyset_{e2}$) et que la troisième tension d'horloge ($\emptyset_{g2}$) passe alternativement de l'une à l'autre de deux valeurs de tension dont la plus élevée ne descend pas en-dessous de la valeur maximale de la tension du signal d'entrée, tandis que la plus basse est inférieure d'une quantité préfixée (a) à la valeur minimale de la tension du signal d'entrée.

3. Etage d'entrée selon la revendication 1 ou 2, caractérisé par son utilisation en combinaison avec un dispositif de déplacement de charges dans lequel deux étage voisins (S(n−1), Sn) sont couplés chacun à un étage de sortie (AS1, AS2) et ces derniers sont reliés aux entrées d'un amplificateur différenciateur (20).

**Claims**

1. An input stage for the input of two complementary charge bunches, formed in dependence upon an input signal, into a monolithic integrated charge transfer device, where a doped semiconductor body is provided with an oppositely-doped zone and at a boundary surface is covered by an electrically-insulating layer, and a first gate is connected to a fixed bias voltage, and an input gate is connected to an input signal, between which gates at least two transfer gate electrodes are located, on the insulating layer, characterised in that a second gate (8) is arranged between the input gate (7) and a series of transfer electrodes (9 ... 13) which cover the transfer channel of the charge transfer device, that the zone (3) and the transfer gate electrodes (5, 6) are connected to first clock-pulse voltages ($u_d$, $\emptyset_{e1}$, $\emptyset_{e2}$), that the transfer electrodes (9 ... 13) are connected to second clock-pulse voltages ($\emptyset 1$ to $\emptyset 4$), the clock frequency of which is double that of the first clock-pulse voltages ($u_d$, $\emptyset_{e1}$, $\emptyset_{e2}$), that the second gate (8) is connected to a third clock-pulse voltage ($\emptyset_{g1}$), the clock frequency of which corresponds to that of the second clock pulse voltages ($\emptyset 1$ to $\emptyset 4$) and that the third clock-pulse voltage ($\emptyset_{g1}$)

alternates between two voltage levels, of which the upper voltage level does not fall below the maximum signal voltage level whereas the lower voltage level is a predetermined amount (a) below the minimum signal voltage level.

2. An input stage for the input of two complementary charge bunches, formed in dependence upon an input signal, into a monolithic integrated charge transfer device, where a doped semiconductor body is provided with an oppositely-doped zone and is covered at a boundary surface by an electrically-insulating layer, and where a first gate, is connected to a fixed bias voltage and an input gate is connected to an input signal, between which gates at least two transfer gate electrodes are arranged on the insulating layer, characterised in that a second gate (8) is arranged between the input gate (7) and a series of transfer electrodes (9 ... 13) which cover the transfer channel of the charge transfer device, that the zone (3) and the transfer gate electrodes (5, 6) are connected to first clock-pulse voltages ($u_d$, $\emptyset_{e1}$, $\emptyset_{e2}$), that the transfer electrodes (9 ... 13) are connected to second clock-pulse voltages ($\emptyset 1$ to $\emptyset 4$), the clock frequency of which is double that of the first clock-pulse voltages ($u_d$, $\emptyset_{e1}$, $\emptyset_{e2}$), that the second gate (8) is connected to a third clock-pulse voltage ($\emptyset_{g2}$), the clock frequency of which corresponds to that of the first clock pulse voltages ($u_d$, $\emptyset_{e1}$, $\emptyset_{e2}$) and that the third clock-pulse voltage ($\emptyset_{g2}$) alternates between two voltage levels of which the upper voltage level does not fall below the maximum signal voltage level whereas the lower voltage level corresponds to the minimum signal voltage level.

3. An input stage as claimed in one of the Claims 1 or 2, characterised by the use thereof in a charge transfer device in which two adjacent stages (S(n−1), Sn) are each coupled to an associated output stage (AS1, AS2) and the latter are connected to the inputs of a differential amplifier (20).

# FIG 1

FIG 2

# FIG 3

U_d  U1  $\Phi_{e1}$  $\Phi_{e2}$  7a  $\Phi_{g2}$  $\phi1$  $\phi2$  $\phi3$  $\phi4$  $\phi1$
($u_e$)

2
1a
1

3  4  5  6  7  8  9  10  11  12  13

ES2

P50  P60  F1'

$\Phi_{s3}$  P4  P5  F2'  P80'

P51  P61

P91  F1'

P3

# FIG 4

9 10 11 12 13        S(n-1)   Sn

7a
($u_e$)

AS1      AS2

20

21 ($u_a$)